(19) Europäisches Patentamt
European Patent Office
Office européen des brevets

(11) EP 1 422 282 A1

(12) # EUROPEAN PATENT APPLICATION
published in accordance with Art. 158(3) EPC

(43) Date of publication:
**26.05.2004 Bulletin 2004/22**

(21) Application number: **02760709.2**

(22) Date of filing: **22.08.2002**

(51) Int Cl.[7]: **C09K 11/06**, H05B 33/12

(86) International application number:
**PCT/JP2002/008476**

(87) International publication number:
**WO 2003/020846 (13.03.2003 Gazette 2003/11)**

(84) Designated Contracting States:
**AT BE BG CH CY CZ DE DK EE ES FI FR GB GR IE IT LI LU MC NL PT SE SK TR**

(30) Priority: **30.08.2001 JP 2001260608**

(71) Applicant: **IDEMITSU KOSAN CO., LTD.**
**Tokyo 100-8321 (JP)**

(72) Inventors:
- **HACHIYA, Satoshi**
  **Sodegaura-shi, Chiba 299-0205 (JP)**
- **EIDA, Mitsuru**
  **Sodegaura-shi, Chiba 299-0205 (JP)**
- **FUKUDA, Masahiko**
  **Sodegaura-shi, Chiba 299-0205 (JP)**
- **KUMA, Hitoshi**
  **Sodegaura-shi, Chiba 299-0205 (JP)**

(74) Representative:
**Gille Hrabal Struck Neidlein Prop Roos**
**Patentanwälte,**
**Brucknerstrasse 20**
**40593 Düsseldorf (DE)**

(54) **COLOR−CHANGING MATERIAL COMPOSITION AND COLOR−CHANGING MEMBRANES MADE BY USING THE SAME**

(57) A color-changing material composition which comprises a binder resin comprising a copolymer of a methacrylic ester and methacrylic acid having a specific structure (Component A), at least one fluorescent coloring matter (Component B) and a monomer and/or oligomer having a photopolymerizable ethylenically unsaturated group (Component C) and color-changing membranes formed by curing the color-changing material composition are provided. Degradation of the color-changing membrane due to continuous lighting of a light source can be decreased, the increase in viscosity of the composition can be suppressed, and deterioration of rhodamine can be prevented by using the color-changing material composition and the color-changing membrane using the composition.

EP 1 422 282 A1

## Description

### TECHNICAL FIELD

The present invention relates to a color-changing material composition and color changing membranes made by using the composition and, more particularly, to a color-changing material composition which decreases degradation of the color-changing membrane due to continuous lighting of a light source, suppresses the increase in viscosity of the composition and prevents deterioration of rhodamine and color-changing membranes made by using the composition.

### BACKGROUND ART

Since organic electroluminescence ("electroluminescence" will be referred to as "EL", hereinafter) devices are completely solid devices, and displays having a light weight and a small thickness and driven under a small voltage can be prepared, various developments on the organic EL devices are being conducted. When the organic EL devices is used for displays, it is most urgently desired that a method for full color displaying is developed. For preparing a full color display, it is necessary that blue, green and red light emissions be finely arranged. At present, three method are available for this purpose, which are the method of arranging separate areas of the three colors, the method of using color filters and the method of color change.

The method of color change has advantages in that a display having a great area is more easily provided in accordance with this method than in accordance with the method of arranging separate areas of the three colors and that the loss in the luminance is smaller in accordance with this method than in accordance with the method of using color filters. Therefore, the present inventors have been studying preparation of a full color display using an organic EL device in accordance with the method of color change.

When a full color display is prepared in accordance with the method of color change, it is necessary that the color-changing membranes used for changing emitted blue light into green light and red light be finely patterned. The color-changing membrane is constituted with a fluorescent coloring matter and a resin in which the coloring matter is dispersed. For the fine patterning of the color-changing membrane, fine working on the resin itself is necessary. For this purpose, for example, a color-changing material composition using a basic resin such as a vinyl pyridine derivative or an aminostyrene derivative is used in Japanese Patent Application Laid-Open No. Heisei 9(1997)-208944; a color-changing material composition using a copolymer of an ethylenically unsaturated carboxylic acid is disclosed in Japanese Patent Application Laid-Open No. Heisei 9(1997)-106888; and a color-changing material composition which contains a compound having an unsaturated group obtained by the reaction of a reaction product of an epoxy compound and acrylic acid or methacrylic acid with a polybasic carboxylic acid or an anhydride thereof and at least one fluorescent compound selected from fluorescent coloring matters and fluorescent pigments, is disclosed in Japanese Patent Application Laid-Open No. Heisei 2000-119645.

However, the above color-changing material compositions have drawbacks in that, when a color-changing membrane containing a rhodamine-based coloring matter is continuously irradiated with blue light emitted from an organic EL device, the intensity of light emitted from the rhodamine-based coloring matter decreases very quickly; that rhodamine is decomposed into a leuco compound, and the desired light emission cannot be obtained in the cases of some compositions; and that viscosity of the composition increases due to the reaction of rhodamine, and workability of the color-changing membrane is adversely affected in the cases of some compositions.

### DISCLOSURE OF THE INVENTION

The present invention has been made to overcome the above drawbacks and has an object of providing a color-changing material composition which decreases degradation of the color-changing membrane due to continuous lighting of a light source, suppresses the increase in viscosity of the composition and prevents deterioration of rhodamine and a color-changing membrane made by using the composition.

As the result of intensive studies by the present inventors to achieve the above object, it was found that the degradation of the color-changing membrane decreased when a copolymer of benzyl methacrylate and methacrylic acid was used as the binder resin of the color-changing material composition, and the increase in viscosity of the composition could be suppressed and deterioration of rhodamine could be prevented when a compound having epoxy group was added to the color-changing material composition. The present invention has been completed based on this knowledge.

The present invention provides a color-changing material composition which comprises a binder resin comprising a copolymer of a methacrylic ester and methacrylic acid represented by general formula (I) (Component A), at least one fluorescent coloring matter (Component B) and at least one of monomers and oligomers having a photopolymerizable ethylenically unsaturated group (Component C), general formula (I) being:

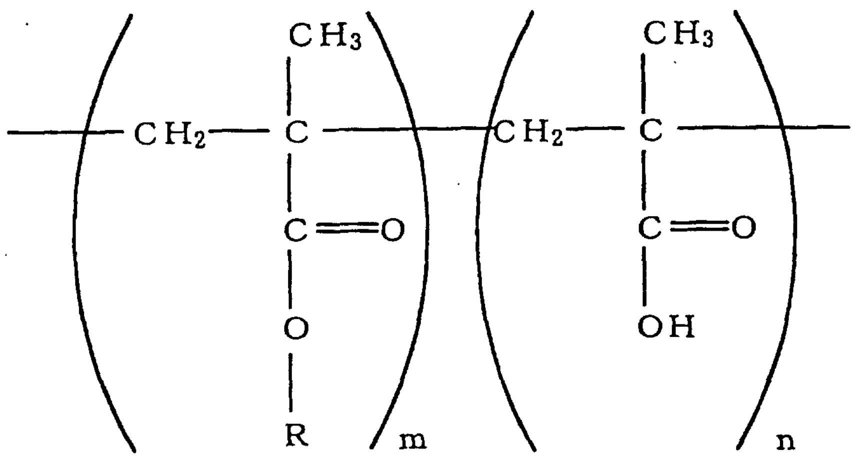

(I)

wherein R represents (i) a substituted or unsubstituted linear, branched or cyclic alkyl group having 1 to 10 carbon atoms or (ii) -$CH_2$-Ar, Ar representing a substituted or unsubstituted aromatic ring group having 6 to 20 carbon atoms, and m and n each represent an integer of 1 or greater.

## BRIEF DESCRIPTION OF THE DRAWINGS

Figure 1 shows a diagram exhibiting the construction of an organic EL device for full color displays used in the evaluation of durability in Examples and Comparative Examples.

1 means a glass substrate, 2 means a color-changing membrane, 3 means an anode, 4 means an organic EL light emitting layer, and 5 means a cathode.

## THE MOST PREFERRED EMBODIMENT TO CARRY OUT THE INVENTION

The color-changing material composition of the present invention comprises a binder resin comprising a copolymer of a methacrylic ester and methacrylic acid represented by the above general formula (I) (Component A), at least one fluorescent coloring matter (Component B) and at least one of monomers and oligomers having a photopolymerizable ethylenically unsaturated group (Component C).

In general formula (I), R represents (i) a substituted or unsubstituted linear, branched or cyclic alkyl group having 1 to 10 carbon atoms or (ii) -$CH_2$-Ar (Ar representing a substituted or unsubstituted aromatic ring group having 6 to 20 carbon atoms) and preferably methyl group, ethyl group, cyclohexyl group, cyclohexylmethyl group, hydroxyethyl group or benzyl group. m and n each represent an integer of 1 or greater.

It is preferable that the weight-average molecular weight of Component A is in the range of 5,000 to 100,000 and more preferably in the range of 10,000 to 50,000. When the weight-average molecular weight is smaller than 5,000, the strength of the color-changing membrane formed from the color-changing material composition is small. When the weight-average molecular weight exceeds 100,000, viscosity of the color-changing material composition increases, and the thickness occasionally becomes uneven when the color-changing membrane is formed.

It is preferable that the copolymer ratio q=m(m+n) of Component A is in the range of 0.4 to 0.9 and more preferably in the range of 0.6 to 0.8. When q is smaller than 0.4, the accuracy of patterning of the color-changing membrane formed from the color-changing material composition decreases, occasionally. When q exceeds 0.9, the photolithography cannot be conducted, occasionally.

As the fluorescent coloring matter of Component B, fluorescent coloring matters having excellent resistance to heat and light are preferable. For example, coumarine-based coloring matters, perylene-based coloring matters, phthalocyanine-based coloring matters, stilbene-based coloring matters, cyanine-based coloring matters, polyphenylene-based coloring matters and rhodamine-based coloring matters are advantageously used.

As the fluorescent coloring matter which changes near ultraviolet to violet light into blue light, for example, stilbene-based coloring matters such as 1,4-bis(2-methylstyryl)benzene (Bis-MSB) and trans-4,4'-diphenylstilbene (DPS) and coumarine-based coloring matters such as 7-hydroxy-4-methylcoumarine (Coumarine 4) are advantageously used.

As the fluorescent coloring matter which changes blue or bluish green light into green light, for example, coumarine-based coloring matters such as 6-1H,4H-tetrahydro-8-trifluoromethylquinolidine-(9,9a,1-gh)coumarine (Coumarine 153), 3-(2'-benzothiazolyl)-7-diethylaminocoumarine (Coumarine 6), 3-(2'-N-benzimidazolyl)-7-N,N-diethylaminocoumarine (Coumarine 7) and 3-(2'-methylbenzimidazolyl)-7-N,N-diethylaminocoumarine (Coumarine 30); coumarine coloring matter-based dyes such as Basic Yellow-51; and naphthalimide-based coloring matters such as Solvent Yellow-11 and Solvent Yellow-116 are advantageously used.

As the fluorescent coloring matter which changes blue to bluish green light into orange to red light, for example, cyanine-based coloring matters such as 4-dicyanomethylene-2-methyl-6-(p-dimethylaminostyryl)-4H-pyran (DCM); pyridine-based coloring matters such as 1-ethyl-2- [4-(p-dimethylaminophenyl)-1,3-butadienyl pyridinium perchlorate] (Pyridine 1); rhodamine-based coloring matters such as Rhodamine B and Rhodamine 6G; and oxazine-based coloring matters are advantageously used.

Various dyes (direct dyes, acidic dyes, basic dyes and dispersion dyes) can also be used as long as the dyes have the fluorescent property.

The fluorescent coloring matter may be used in the form of a pigment after being mixed with a resin in advance. The fluorescent coloring matter in the form of a pigment is the fluorescent pigment. The fluorescent coloring matter and the fluorescent pigment may be used singly or in combination of two or more.

Among the above fluorescent coloring matters, the coloring matters comprising at least one coloring matter selected from the coumarine-based coloring matters and at least one coloring matter selected from the rhodamine-based coloring matters are preferable.

It is preferable that the color-changing material composition comprises 0.1 to 10% by weight and more preferably 0.2 to 5% by weight of Component B based on the amount of the entire color-changing material composition. When the concentration of Component B is smaller than 0.1% by weight, there is the possibility that the formed color-changing membrane does not sufficiently change the color. When the concentration exceeds 10% by weight, the efficiency of the color change occasionally decreases due to quenching by concentration, or the highly accurate patterning occasionally cannot be achieved.

The smaller the concentration of the fluorescent coloring matter, the smaller the deterioration of light emission under continuous irradiation of the organic EL device with blue light. Therefore, it is preferable that the concentration is set at the minimum value within the range of the concentration providing the optimum light emission.

The color-changing material composition of the present invention comprises at least one of monomers and oligomers having a photopolymerizable ethylenically unsaturated group (Component C). It is preferable that Component C is at least one of monomers and oligomers having a photopolymerizable ethylenically unsaturated group having hydroxyl group.

It is preferable that the color-changing material composition comprises 10 to 200 parts by weight and more preferably 30 to 150 parts by weight of Component (C) based on 100 parts by weight of Component A. When the amount of Component C is smaller than 10 parts by weight, there is the possibility that the formed color-changing membrane exhibits poor solvent resistance. When the amount exceeds 200 parts by weight, there is the possibility that a problem arises on the tackiness after procuring.

Examples of Component C include monomers having hydroxyl group such as 2-hydroxyethyl (meth)acrylate, 2-hydroxypropyl (meth)acrylate and 2-hydroxyhexyl (meth)acrylate; and (meth)acrylic esters such as ethylene glycol di(meth)acrylate, diethylene glycol di(meth)acrylate, triethylene glycol di(meth)acrylate, tetraethylene glycol di(meth) acrylate, tetramethylene glycol di(meth)acrylate, trimethylol- propane tri(meth)acrylate, pentaerythritol di(meth)acrylate, pentaerythritol tri(meth)acrylate, pentaerythritol tetra(meth)acrylate, dipentaerythritol hexa(meth)acrylate and glycerol (meth)acrylate. The above compound may be used singly or in combination of two or more.

The color-changing material composition of the present invention may further comprise a compound having epoxy group (Component D) in combination with Components A, B and C. It is preferable that the amount of Component D is in the range of 0.1 to 15% by weight and more preferably in the range of 0.5 to 7% by weight based on the amount of the entire color-changing material composition. The increase in viscosity can be suppressed and deterioration of rhodamine can be prevented when the color-changing material composition of the present invention comprises Component D.

As Component D, epoxy resins of the phenol-novolak-type and epoxy resins of the cresol-novolak type can be advantageously used. By heating after the photopolymerization of Component C, the product of the photocrosslinking and the epoxy resin of Component D are crosslinked together, and the crosslinking density of the membrane can be increased.

The color-changing material composition of the present invention may further comprise a photopolymerization initiator or a photopolymerization sensitizer, where necessary.

The photopolymerization initiator and the photopolymerization sensitizer can be used not only for the photocuring reaction of Component A but also as the polymerization initiator for photopolymerizable unsaturated compounds

such as (meth)acrylic monomers and (meth)acrylic oligomers which are used where necessary.

As the photopolymerization initiator, for example, acetophenones, benzophenones, benzoin ethers, sulfur compounds, anthraquinones, organic peroxides and thiols are advantageously used.

Specific examples of the above compounds include acetophenones such as acetophenone, 2,2-diethoxyacetophenone, p-dimethylacetophenone, p-dimethylaminopropiophenone, dichloroacetophenone, trichloroacetophenone and p-t-butylacetophenone; benzophenones such as benzophenone, 2-chlorobenzophenone and p,p'-bisdimethylaminobenzophenone; benzoin ethers such as benzyl, benzoin, benzoin methyl ether, benzoin isopropyl ether and benzoin isobutyl ether; sulfur compounds such as benzyl methyl ketal, thioxanthone, 2-chlorothioxanthone, 2,4-diethylthioxanthone, 2-methylthioxanthone and 2-isopropylthioxanthone; anthraquinones such as 2-ethylanthraquinone, octamethylanthraquinone, 1,2-benzanthraquinone and 2,3-diphenylanthraquinone; organic peroxides such as azobisisobutyronitrile, benzoyl peroxide and cumene peroxide, and thiols such as 2-mercaptobenzoxazole and 2-mercaptobenzothiazole.

The photopolymerization initiator and the photopolymerization sensitizer may be used singly or in combination of two or more.

Compounds which do not work as the photopolymerization initiator or the photopolymerization sensitizer by themselves but can increase the ability of the photopolymerization initiator or the photopolymerization sensitizer when used in combination can also be added. Examples of the above compound include tertiary amines such as triethanolamine which exhibits the effect when used in combination with the benzophenones.

The amount of the photopolymerization initiator and the photopolymerization sensitizer is not particularly limited. In general, an amount in the range of 10 parts by weight or smaller based on 100 parts by weight of Component C is preferable. When the amount exceeds 10 parts by weight, uncured portion remains since it is difficult that light reaches inner portions. There is the possibility that this causes deterioration in physical properties such as a decrease in adhesion between the substrate and the resin and a decrease in the phosphorescent property of the coloring matter.

In the present invention, it is also possible that a resin having a great dielectric constant is added so that the fluorescence yield of the florescent coloring matter is increased. Examples of the above resin include transparent resins such as melamine resins, phenol resins, alkyd resins, polyurethane resins, polyester resins, oligomers and polymers of polyamide resins, polyvinyl alcohol, polyvinyl hydrin, hydroxyethylcellulose, carboxymethylcellulose, aromatic sulfonamide resins, urea resins and benzoguanamine resins. Among these resins, melamine resins and benzoguanamine resins are preferable.

It is necessary that the above monomers and oligomers be used within the range such that the properties of the composition of the present invention and the cured products thereof are not adversely affected. The amount is not particularly limited. In general, it is preferable that the amount is 200 parts by weight or smaller based on 100 parts by weight of Component A. When the amount exceeds 200 parts by weight, there is the possibility that a problem arises on the tackiness after precuring. It is more preferable that the amount is 100 parts by weight or smaller.

The color-changing material composition of the present invention may further comprise additives such as curing accelerators, inhibitors for thermal polymerization, plasticizers, fillers, solvents, defoaming agents and leveling agents. Examples of the curing accelerator include derivatives of perbenzoic acid, peracetic acid and benzophenone. Examples of the inhibitor for thermal polymerization include hydroquinone, hydroquinone monomethyl ether, pyrogallol, t-butylcatechol and phenothiazine. Examples of the plasticizer include dibutyl phthalate, dioctyl phthalate and tricresyl phosphate. Examples of the filler include glass fibers, silica, mica and alumina. Examples of the defoaming agent and the leveling agent include silicone-based compounds, fluorine-based compounds and acrylic compounds.

For adding the additives described above into the color-changing material composition, the additives may be dissolved into a solvent when it is suitable for the process for producing the color-changing membrane. As the solvent, ketones, cellosolves and lactones are used. Examples of the ketone include methyl ethyl ketone, methyl isobutyl ketone and cyclohexanone. Examples of the cellosolve include methylcellosolve, ethylcellosolve, butylcellosolve and cellosolve acetate. Examples of the lactone include γ-butyrolactone.

The color-changing membrane of the present invention absorbs light from a light source and emits light having a longer wavelength. The color-changing material composition described above is used for the membrane. The membrane is formed by curing the composition or formed in accordance with the photolithography. It is preferable that the membrane is formed in accordance with the photolithography.

The color-changing membrane of the present invention can be prepared in accordance with a conventional process. The photo-sensitive color-changing material composition described above is formed into a solution and applied to the surface of a substrate. After the formed coating layer is precured so that the solvent is removed and the formed layer is dried (the pre-baking), a photomask is placed on the obtained film, and the exposed portion of the film is cured by irradiation with an active light. A pattern is formed by development in which the unexposed portion of the film is dissolved with a weakly alkaline aqueous solution, and the post-baking is conducted by drying the formed pattern.

As the substrate to which the solution of the color-changing material composition of the present invention is applied, a flat and smooth substrate having a transmittance of light in the visible region of 400 to 700 nm of 50% or

greater is preferable. Specifically, glass substrates and polymer plates are used. Specific examples of the glass plate include plates made of soda ash glass, glass containing barium and strontium, lead glass, aluminosilicate glass, borosilicate glass, barium borosilicate glass and quartz. Specific examples of the polymer plate include plates made of polycarbonate resins, acrylic resins, polyethylene terephthalate resins, polyether sulfide resins and polysulfone resins.

As the process for applying the solution of the color-changing material composition of the present invention to the substrate, any of the conventional processes such as the solution dipping process and the spraying process can be used, and other processes such as the processes using a roller coater, a land coater and a spinner can also be used. After the composition is applied to form a coating layer having a desired thickness in accordance with the above process, the solvent is removed (the pre-baking), and a coating film is formed.

The pre-baking is conducted by heating in an oven or on a heated plate. The temperature and the time of heating in the pre-baking are suitably selected in accordance with the used solvent. For example, the pre-baking is conducted at a temperature in the range of 80 to 150°C for a time in the range of 1 to 30 minutes.

The exposure to light after the pre-baking is conducted using an exposing machine. The portion of the resist which corresponds to the pattern is exposed to light by the exposure through the photomask. The exposing machine and the condition of the exposure can be suitably selected. As the light for the exposure, for example, visible light, ultraviolet light, X-ray or electron beams can be used. The amount of light used for the exposure is not particularly limited. The amount of light is, for example, selected in the range of 1 to 3,000 $mJ/cm^2$.

The development with an alkali after the exposure is conducted to remove the resist in the unexposed portion. The desired pattern is formed by the development. As the developing solution suitable for the development with an alkali, for example, an aqueous solution of carbonate of an alkali metal or an alkaline earth metal can be used. It is preferable that the development is conducted using a weakly alkaline aqueous solution containing 1 to 3% by weight of a carbonate such as sodium carbonate, potassium carbonate and lithium carbonate at 10 to 50°C and more preferably at 20 to 40°C. Fine images can be accurately reproduced using a commercial developing machine or a ultrasonic cleaning machine.

After the development described above, in general, the heat treatment (the post-baking) is conducted under a condition of 80 to 220°C for 10 to 120 minutes. The post-baking is conducted to enhance the adhesion between the patterned color-changing membrane and the substrate. The post-baking is conducted by heating in an oven or on a heat plate similarly to the pre-baking.

The patterned color-changing membrane of the present invention is formed in accordance with the so-called photolithography via the steps described above.

As for the thickness of the color-changing membrane of the present invention, it is necessary that a thickness required for changing the incident light into the light having the desired wavelength be suitably selected. In general, the thickness is selected in the range of 1 to 100 μm and preferably in the range of 1 to 20 μm.

To obtain light having the desired wavelength, a color filter may be used in combination so that the purity of color can be adjusted. As the color filter, coloring matters such as perylene-based pigments, lake pigments, azo-based pigments, quinacridone-based pigments, anthraquinone-based pigments, anthracene-based pigments, isoindoline-based pigments, isoindolinone-based pigments, phthalocyanine-based pigments, triphenylmethane-based pigments, indanthrone-based pigments, indophenol-based pigments, cyanine-based pigments and dioxazine-based pigments can be advantageously used singly or in combination of two or more. Solid materials obtained by dissolving the coloring matters into a binder resin or by decomposing the coloring matters in a binder resin can also be advantageously used.

Examples of the construction in practical applications of the color-changing membrane of the present invention are shown in the following.

(1) Light source / color-changing membrane
(2) Light source / substrate / color-changing membrane
(3) Light source / color-changing membrane / substrate
(4) Light source / substrate transmitting light / color-changing membrane / substrate
(5) Light source / color-changing membrane / color filter
(6) Light source / substrate / color-changing membrane / color filter
(7) Light source / color-changing membrane / substrate / color filter
(8) Light source / substrate / color-changing membrane / substrate / color filter
(9) Light source / substrate / color-changing membrane / color filter / substrate
(10) Light source / color-changing membrane / color filter / substrate

When the above construction is used, the constituting elements may be successively laminated or adhered together. The procedure of lamination of the elements is not particularly limited. The elements may be laminated in the order of the left element to the right element or in the order of the right element to the left element.

Examples of the light source for the color-changing membrane include organic EL devices, LED devices, cold

cathode tubes, inorganic EL devices, fluorescent lamps and incandescent lamps. Among these light sources, organic EL devices and LED devices which do not emit much amount of UV light degrading fluorescent coloring matters are preferable.

The present invention will be described more specifically with reference to examples in the following. However, the present invention is not limited to the examples.

In Examples shown in the following, various evaluations of a color-changing membrane were conducted in accordance with the following methods.

(1) Evaluation of the relative fluorescence intensity of a color-changing membrane

A color-changing membrane was placed on top of a blue organic EL device having the peak wavelength at 470 nm. The spectrum of the light transmitted through the color-changing membrane was measured using a spectrometric luminance meter (manufactured by MINOLTA Co., Ltd.; CS 1000) in a visual field of 2 degrees. The obtained result was compared with the spectrum of the light emitted from the blue organic EL device, and the relative fluorescence intensity of the color-changing membrane was calculated in accordance with the following equation:

Relative fluorescence intensity = (peak intensity of light transmitted through the color-changing membrane) / (peak intensity of the blue organic EL device)

(2) Evaluation of durability of a color-changing membrane

A specific example of the construction of the organic EL device for full color displays using the combination of a color-changing membrane and an organic EL device is shown in Figure 1. As shown in Figure 1, the organic EL device for full color displays was composed of a glass substrate 1, a color-changing membrane 2, an anode 3, an organic EL light emitting layer 4, and a cathode, disposed in this order from the side of obtaining the light at the outside. Since the organic EL light emitting layer tended to be degraded in the presence of moisture and oxygen, the device was sealed with a glass counter substrate at the side of the cathode 5 in a manner such that the entire device including the color-changing membrane was covered.

For the organic EL device for full color displays having the above construction, it was difficult that the change of the fluorescent property of the color-changing membrane itself with time was measured since the light emitted from the organic EL device as the excited light had a half-life by itself. Therefore, a blue LED having the peak wavelength at 470 nm was used as the excited light source, and a color-changing membrane was arranged in a manner such that the color-changing membrane contacted the light source under the atmosphere of dry nitrogen. The blue LED was lighted continuously at 400 nit for 1,000 hours, and the relative fluorescence intensities of the color-changing membrane measured before and after the test were compared. From the obtained result, the retention of the property of the color-changing membrane was calculated in accordance with the following equation:

Retention of the property = (relative fluorescence intensity after continuous lighting for 1,000 hours) / (initial relative fluorescence intensity)×100%

and the durability of the color-changing membrane itself was evaluated.

Example 1

Methyl methacrylate in an amount of 10 g, 4.5 g of methacrylic acid and 0.14 g of azobisisobutyronitrile were dissolved into 30 g of toluene, and the atmosphere was purged with nitrogen gas. The resultant solution was stirred under heating at 80°C for 2 hours and then at 100°C for 1 hour. After being cooled to the room temperature, the reaction mixture was concentrated under a reduced pressure. The residue was poured into methanol for precipitation, and a copolymer of methyl methacrylate and methacrylic acid (Component A) was obtained (the yield: 97%). The weight-average molecular weight was 22,000, and the copolymer ratio q was 0.64 as measured in accordance with NMR.

The copolymer of methyl methacrylate and methacrylic acid obtained above as Component A in an amount of 2.3 g, 23 mg of Coumarine 6 (manufactured by ALDRICH Company), 23 mg of Rhodamine 6G (manufactured by ALDRICH Company) and 23 mg of Rhodamine B (manufactured by ALDRICH Company) as Component B, 1.5 g of dipentaerythritol hexaacrylate (manufactured by TOA GOSEI Co., Ltd.; ARONIX M-400) as the acrylic monomer of Component C and 0.4 g of an epoxy resin of the cresol novolak type having the repeating unit expressed by the following formula:

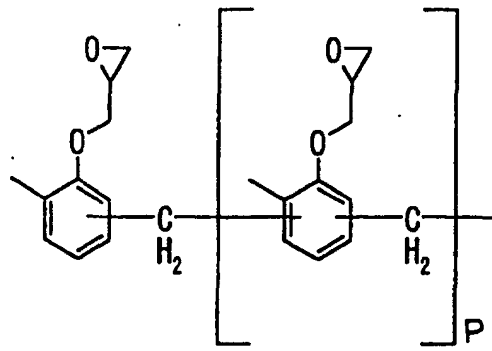

An epoxy resin of the cresol novolak type (p representing an integer of 1 or greater) and a weight-average molecular weight of 1,200 (manufactured by ASAHI KASEI Co., Ltd.; ECN1299) as the epoxy resin of Component D were dissolved into 5.5 g of 2-acetoxy-1-ethoxypropane (manufactured by WAKO JUN-YAKU Co., Ltd.), and a solution of a color-changing material composition was obtained.
The contents of the components of Component B based on the amount of the entire color-changing material composition were as follows: Coumarine 6: 0.59% by weight; Rhodamine 6G: 0.59% by weight; and Rhodamine B: 0.59% by weight.
Using the obtained solution of the color-changing material composition, a film was formed on a glass substrate having a size of 2.5 cm × 5 cm in accordance with the spin coating process. As for the conditions of the film formation, the rotation speed of the spin coater was 500 rpm, the time of rotation was 10 seconds, and the formed film was dried at 80°C for 15 minutes. The resultant film was exposed to ultraviolet light of 300 mJ/$cm^2$ and then treated by heating at 180°C for 30 minutes, and a color-changing membrane having a thickness of 10 μm or smaller was obtained.
The initial relative fluorescence intensity of the obtained color-changing membrane was measured and found to be 0.325. The retention of the property showing the durability was as excellent as 68.4%, and the degradation of the color-changing membrane was small.

Example 2

Benzyl methacrylate in an amount of 10 g, 2 g of methacrylic acid and 0.12 g of azobisisobutyronitrile were dissolved into 25 g of toluene, and the atmosphere was purged with nitrogen gas. The resultant solution was stirred under heating at 80°C for 2 hours and then at 100°C for 1 hour. After being cooled to the room temperature, the reaction mixture was concentrated under a reduced pressure. The residue was poured into methanol for precipitation, and a copolymer of benzyl methacrylate and methacrylic acid (Component A) was obtained (the yield: 95%). The weight-average molecular weight was 27,000, and the copolymer ratio q was 0.72 as measured in accordance with NMR.
In accordance with the same procedures as those conducted in Example 1 except that 1.9 g of Component A obtained above was used and Component B, Component C and Component D of the types shown in Table 1 were used in the amounts shown in Table 1, a solution of a color-changing material composition was prepared, and a color-changing membrane was obtained.
The initial relative fluorescence intensity and the retention of the property of the obtained color-changing membrane were measured. The results are shown in Table 2.

Example 3

In accordance with the same procedures as those conducted in Example 1 except that 2.3 g of the copolymer of methyl methacrylate and methacrylic acid obtained in Examples 1 was used as Component A and Component B, Component C and Component D of the types shown in Table 1 were used in the amounts shown in Table 1, a solution of a color-changing material composition was prepared, and a color-changing membrane was obtained.

The initial relative fluorescence intensity and the retention of the property of the obtained color-changing membrane were measured. The results are shown in Table 2.

Example 4

In accordance with the same procedures as those conducted in Example 1 except that 1.9 g of the copolymer of benzyl methacrylate and methacrylic acid obtained in Examples 2 was used as Component A and Component B, Component C and Component D of the types shown in Table 1 were used in amounts shown in Table 1, a solution of a color-changing material composition was prepared, and a color-changing membrane was obtained.

The initial relative fluorescence intensity and the retention of the property of the obtained color-changing membrane were measured. The results are shown in Table 2.

Table 1

| | Example 2 | Example 3 | Example 4 |
|---|---|---|---|
| Binder resin (Component A) | copolymer of benzyl methacrylate and methacrylic acid (Mw=27,000) 1.9 g | copolymer of methyl methacrylate and methacrylic acid (Mw=22,000) 2.3 g | copolymer of benzyl methacrylate and methacrylic acid (Mw=27,000) 1.9 g |
| Florescent coloring matter(Component B) number in (): amount based on amount of entire color-changing material composition | (1) Coumarine 6 (ALDRICH) 11 mg (0.26% by wt.) (2) Rhodamine 6G (ALDRICH) 16 mg (0.38% by wt.) (3) Compound 1* 16 mg (0.38% by wt.) | (1) Coumarine 6 (ALDRICH) 10 mg (0.26% by wt.) (2) Rhodamine 6G (ALDRICH) 14 mg (0.36% by wt.) (3) Rhodamine B (ALDRICH) 14 mg (0.36% by wt.) | (1) Coumarine 6 (ALDRICH) 9.5 mg (0.25% by wt.) (2) Rhodamine 6G (ALDRICH) 14 mg (0.37% by wt.) (3) Compound 2* 14 mg (0.37% by wt.) |
| Monomer/oligomer (Component C) | dipentaerythritol hexaacrylate (TOA GOSEI Co.; ARONIX M-400) 1.5 g | the same as Example 2 | the same as Example 2 |
| Epoxy compound (Component D) | epoxy resin of cresol novolak type (Mw=1,200) (ASAHI KASEI Co.; ECN1299) 0.40 g | epoxy resin of cresol novolak type (Mw=1,200) (ASAHI KASEI Co.; ECN1299) 0.10 g | none |
| Other components | benzoguanamine resin (Mw=1,000) (SYNLEUCH Co.) 0.37 g | benzoguanamine resin (Mw=1,000) (SYNLEUCH Co.) 0.32 g | benzoguanamine resin (Mw=1,000) (SYNLEUCH Co.) 0.32 g |

Notes Names in () shows the manufacturer.

* Compounds 1 and 2 are compounds shown in the following synthesized in accordance with the process described in Japanese Patent Application Laid-Open No. 2001-164245:

Table 1 (continued)

| | Example 2 | Example 3 | Example 4 |
|---|---|---|---|
| Solvent | 2-acetoxy-1-ethoxy-propane (WAKO JUN-YAKU Co.) 5.1g | 2-acetoxy-1-ethoxy-propane (WAKO JUN-YAKU Co.) 4.7 g | 2-acetoxy-1-ethoxy-propane (WAKO JUN-YAKU Co.) 4.6 g |

Compound 1 in Example 2

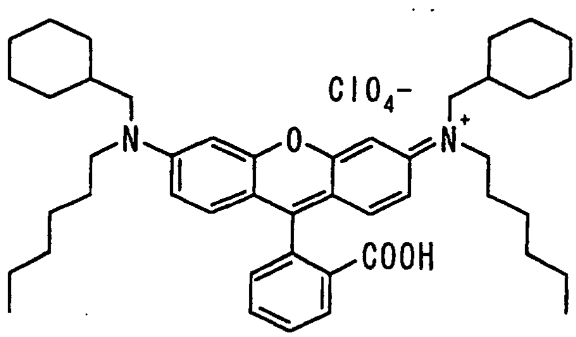

Compound 2 in Example 4

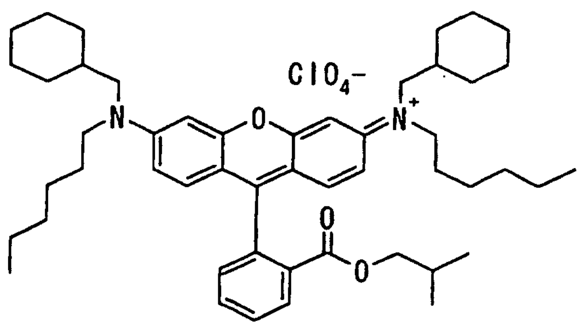

Table 2

| | Initial relative fluorescence intensity | Retention of property (%) |
|---|---|---|
| Example 2 | 0.327 | 78.3 |
| Example 3 | 0.276 | 73.2 |
| Example 4 | 0.258 | 88.1 |

Comparative Example 1

A solution of a color-changing material composition was obtained in accordance with the same procedures as those conducted in Example 1 using 8.0 g of a polymer V259PA manufactured by SHIN NITTETSU KAGAKU Co., Ltd. and having a weight-average molecular weight of 4,000 and the structure represented by the following formula:

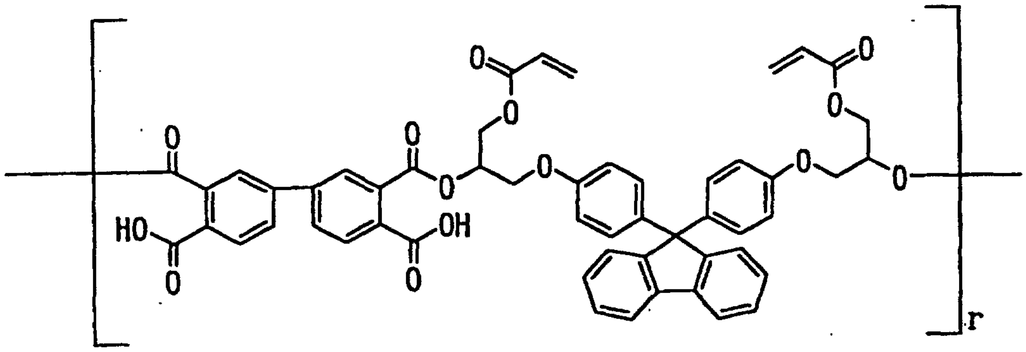

V259PA

(r representing an integer of 1 or greater) as Component A, 24 mg of Coumarine 6 (manufactured by ALDRICH Company), 24 mg of Rhodamine 6G (manufactured by ALDRICH Company) and 24 mg of Rhodamine B (manufactured by ALDRICH Company) as Component B, and 0.59 g of a benzoguanidine resin having a weight-average molecular weight of 1,000 (manufactured by SYNLEUCH Company) as the other component and dissolving these components into 5.7 g of 2-acetoxy-1-ethoxypropane (manufactured by WAKO JUN-YAKU Co., Ltd.).

The contents of the components of Component B based on the amount of the entire color-changing material composition were as follows: Coumarine 6: 0.51% by weight; Rhodamine 6G: 0.51% by weight; and Rhodamine B: 0.51% by weight.

Using the obtained solution of the color-changing material composition, a color-changing membrane was prepared in accordance with the same procedures as those conducted in Example 1.

The relative fluorescence intensity of the obtained color-changing membrane was measured, and the initial fluorescence intensity was found to be 0.292. The retention of the property showing the durability was 46.2% The color changing membrane showed markedly great degradation and could not be used practically.

INDUSTRIAL APPLICABILITY

As described in detail in the above, the color-changing membrane obtained from the color-changing material composition of the present invention decreases the degradation of the color-changing membrane due to continuous lighting of the light source, suppresses the increase in viscosity of the composition and prevents deterioration of rhodamine.

Therefore, the color-changing membrane of the present invention can be advantageously used as the color-changing membrane for full color displays of organic EL devices and LED devices.

## Claims

1. A color-changing material composition which comprises a binder resin comprising a copolymer of a methacrylic ester and methacrylic acid represented by general formula (I) (Component A), at least one fluorescent coloring matter (Component B) and at least one of monomers and oligomers having a photopolymerizable ethylenically unsaturated group (Component C), general formula (I) being:

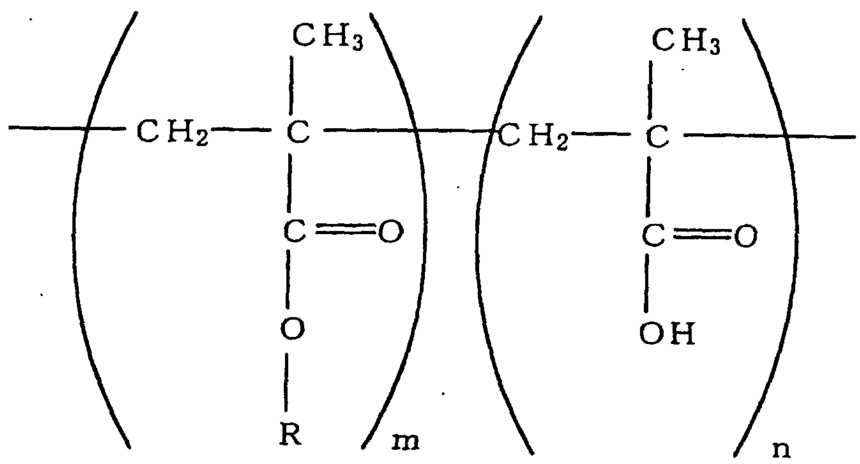

(I)

wherein R represents (i) a substituted or unsubstituted linear, branched or cyclic alkyl group having 1 to 10 carbon atoms or (ii) $-CH_2-Ar$, Ar representing a substituted or unsubstituted aromatic ring group having 6 to 20 carbon atoms, and m and n each represent an integer of 1 or greater.

**2.** A color-changing material composition according to Claim 1, wherein R in general formula (I) represents methyl group, ethyl group, cyclohexyl group, cyclohexylmethyl group, hydroxyethyl group or benzyl group.

**3.** A color-changing material composition according to Claim 1, wherein Component C is at least one of monomers and oligomers having a photopolymerizable ethylenically unsaturated group having hydroxyl group.

**4.** A color-changing material composition according to Claim 1, which comprises 10 to 200 parts by weight of Component C based on 100 parts by weight of Component A.

**5.** A color-changing material composition according to Claim 1, which comprises 0.1 to 15% by weight of a compound having epoxy group (Component D) based on an amount of an entire color-changing material composition.

**6.** A color-changing material composition according to Claim 1, which comprises 0.1 to 10% by weight of Component B based on an amount of an entire color-changing material composition.

**7.** A color-changing material composition according to Claim 1, wherein a weight-average molecular weight of Component A is in a range of 5,000 to 100,000.

**8.** A color-changing material composition according to Claim 1, wherein a copolymer ratio q=m/(m+n) of Component A is in a range of 0.4 to 0.9.

**9.** A color-changing material composition according to Claim 1, wherein the coloring matter of Component B comprises at least one fluorescent coloring matter selected from coumarine-based fluorescent coloring matters and at least one fluorescent coloring matter selected from rhodamine-based fluorescent coloring matters.

**10.** A color-changing membrane formed from a color-changing material composition described in Claim 1.

**11.** A color-changing membrane according to Claim 10, which is formed in accordance with photolithography.

**12.** A color-changing membrane according to Claim 10, which changes a portion of incident light or entire incident light into light having a longer wavelength.

**13.** A color-changing membrane according to Claim 12, wherein a light source of the incident light is an organic electroluminescence device or an LED device.

F i g . 1

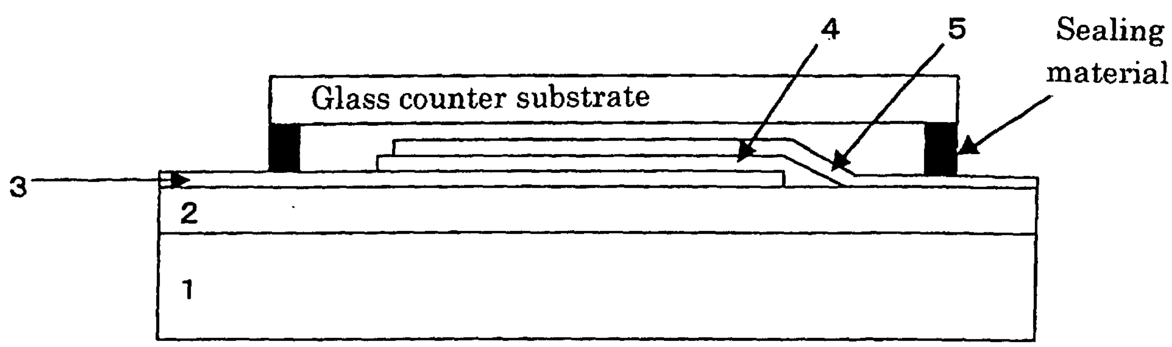

## INTERNATIONAL SEARCH REPORT

International application No.
PCT/JP02/08476

**A. CLASSIFICATION OF SUBJECT MATTER**
Int.Cl$^7$ C09K11/06, H05B33/12

According to International Patent Classification (IPC) or to both national classification and IPC

**B. FIELDS SEARCHED**

Minimum documentation searched (classification system followed by classification symbols)
Int.Cl$^7$ C09K11/06, H05B33/12

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | JP 9-106888 A (Idemitsu Kosan Co., Ltd.),<br>22 April, 1997 (22.04.97),<br>Claims; Par. Nos. [0005], [0010] to [0014]<br>(Family: none) | 1-3,5-13<br>4 |
| Y<br>A | GB 2357889 A (Fuji Electric Co., Ltd.),<br>04 July, 2001 (04.07.01),<br>& JP 2001-126870 A | 1-3,5-13<br>4 |
| Y | JP 2000-119645 A (Idemitsu Kosan Co., Ltd.),<br>25 April, 2000 (25.04.00),<br>Claims; Par. No. [0027]<br>(Family: none) | 5 |
| A | JP 2001-164245 A (Idemitsu Kosan Co., Ltd.),<br>19 June, 2001 (19.06.01),<br>(Family: none) | 1-13 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>28 November, 2002 (28.11.02) | Date of mailing of the international search report<br>10 December, 2002 (10.12.02) |
| Name and mailing address of the ISA/<br>Japanese Patent Office | Authorized officer |
| Facsimile No. | Telephone No. |

Form PCT/ISA/210 (second sheet) (July 1998)

**INTERNATIONAL SEARCH REPORT**

International application No.
PCT/JP02/08476

C (Continuation). DOCUMENTS CONSIDERED TO BE RELEVANT

| Category* | Citation of document, with indication, where appropriate, of the relevant passages | Relevant to claim No. |
|---|---|---|
| A | JP 2000-212554 A (Idemitsu Kosan Co., Ltd.), 02 August, 2000 (02.08.00), & US 6464898 B1 | 1-13 |

Form PCT/ISA/210 (continuation of second sheet) (July 1998)